(19) Europäisches Patentamt
European Patent Office
Office européen des brevets

(11) **EP 1 104 033 B1**

(12) **EUROPÄISCHE PATENTSCHRIFT**

(45) Veröffentlichungstag und Bekanntmachung des Hinweises auf die Patenterteilung:
**21.02.2007   Patentblatt 2007/08**

(51) Int Cl.:
*H01L 39/24* (2006.01)          *C23C 14/28* (2006.01)
*C23C 14/08* (2006.01)

(21) Anmeldenummer: **00125481.2**

(22) Anmeldetag: **21.11.2000**

(54) **Verfahren zur Erzeugung einer supraleitfähigen Schicht**

Manufacturing process for a superconducting layer

Procédé de fabrication d'une couche supraconductrice

(84) Benannte Vertragsstaaten:
**AT BE CH CY DE DK ES FI FR GB GR IE IT LI LU MC NL PT SE TR**

(30) Priorität: **26.11.1999  DE 19957097**
**12.09.2000  DE 10045065**

(43) Veröffentlichungstag der Anmeldung:
**30.05.2001   Patentblatt 2001/22**

(73) Patentinhaber: **European High Temperature Superconductors GmbH & Co. KG**
**63450 Hanau (DE)**

(72) Erfinder:
• **Usoskin, Alexander, Dr.**
**37075 Göttingen (DE)**
• **Freyhardt, Herbert Carl, Prof. Dr.**
**37085 Göttingen (DE)**
• **Knoke, Jürgen, Dipl. Ing.**
**38685 Langelsheim (DE)**

(74) Vertreter: **Lins, Edgar et al**
**Gramm, Lins & Partner GbR,**
**Theodor-Heuss-Strasse 1**
**38122 Braunschweig (DE)**

(56) Entgegenhaltungen:
**EP-A- 0 302 354          EP-A- 0 469 603**
**DE-A- 19 727 343          DE-C- 4 228 573**

• USOSKIN A ET AL: "Variable-azimuth laser ablation: principles and application for film deposition on long tubes and tapes" LASER ABLATION. FIFTH INTERNATIONAL CONFERENCE. COLA'99, GOTTINGEN, GERMANY, 19-23 JULY 1999, Bd. A69, suppl., Seiten 423-425, XP002265908 Applied Physics A (Materials Science Processing), Dec. 1999, Springer-Verlag, Germany ISSN: 0947-8396
• USOSKIN A ET AL: "Large-area HTS coated conductors obtained by a novel PLD technique on metallic substrates" APPLIED SUPERCONDUCTIVITY 1999. PROCEEDINGS OF EUCAS 1999, THE FOURTH EUROPEAN CONFERENCE ON APPLIED SUPERCONDUCTIVITY, APPLIED SUPERCONDUCTIVITY 1999. PROCEEDINGS OF EUCAS 1999, THE FOURTH EUROPEAN CONFERENCE ON APPLIED SUPERCONDUCTIVITY, SITGES, SP, Seiten 447-450 vol.1, XP009023196 2000, Bristol, UK, IOP Publishing, UK ISBN: 0-7503-0694-7
• GREER J A ET AL: "LARGE-AREA PULSED LASER DEPOSITION: TECHNIQUES AND APLLICATIONS" JOURNAL OF VACUUM SCIENCE AND TECHNOLOGY: PART A, AMERICAN INSTITUTE OF PHYSICS. NEW YORK, US, Bd. 13, Nr. 3, PART 1, 1. Mai 1995 (1995-05-01), Seiten 1175-1181, XP000531614 ISSN: 0734-2101

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Erzeugung einer supraleitfähigen Schicht auf einem langgestreckten Substrat, bei dem das Substrat durch eine Depositionskammer gezogen und innerhalb derselben in einer Heizzone beheizt wird, bei dem das Substrat in der Heizzone mit supraleitfähigem Material beschichtet wird, das mittels eines gepulsten Laserstrahls von einem in der Depositionskammer befindlichen, supraleitfähiges Material tragenden Target gelöst und als Plasmastrahl auf dem Substrat abgeschieden wird, und bei dem der Laserstrahl während des Beschichtungsvorgangs in einer gleich bleibenden Ebene so in Schwingungen versetzt wird, dass er eine große Fläche des Targets überstreicht, wobei das Target während des Beschichtungsvorgangs periodisch quer zur Schwingungsebene des Laserstrahls bewegt wird und das Target während des Beschichtungsvorgangs in der Ebene seiner vom Laserstrahl überstrichenen Fläche zusätzlich periodisch um 180° gedreht wird.

Der Effekt der Supraleitung ist seit langem bekannt. Im Falle der Supraleitung verschwindet - zumindest für Gleichstrom - unterhalb einer bestimmten kritischen Temperatur der elektrische Widerstand eines metallischen Leiters. Die kritische Temperatur liegt beispielsweise für das Material $Nb_3Sn$ bei 18,2 K. Als Kühlmedium wird üblicherweise Helium verwendet. Elektrischer Strom kann über Supraleiter nahezu verlustlos übertragen werden. Ein Problem ist neben der Erzeugung der tiefen Temperaturen insbesondere deren Aufrechterhaltung in der Umgebung des Leiters. Es wird daher nach supraleitfähigen Materialien gesucht, die bereits bei weniger tiefen Temperaturen supraleitfähig werden. Solche Hochtemperatursupraleiter(HTSL)-Materialien haben kritische Temperaturen von über 77 K. Sie enthalten beispielsweise die Komponenten Yttrium, Barium, Kupfer und Sauerstoff. Die HTSL-Materialien können beispielsweise mittels eines gepulsten Laserstrahls, durch Plasmaverdampfen, thermisches Verdampfen oder chemisch auf ein beheiztes Substrat aufgebracht werden.

Mit dem bekannten Verfahren nach der DE 42 28 573 C1 können HTSL-Schichten guter Qualität reproduzierbar erzeugt werden. Die mit einem gepulsten Laserstrahl durchgeführte Beschichtung erfolgt bei diesem Verfahren intermittierend. Es ergeben sich dadurch bei der Beschichtung gleichförmige Temperaturverhältnisse für das Substrat und die aufgepulsten Schichten, wodurch die gute Qualität derselben erreicht wird. Die Stromtragfähigkeit der erzeugten Schicht ist allerdings gering. Das Verfahren ist außerdem wegen der niedrigen Abscheidungsrate nur mit geringer Geschwindigkeit durchführbar.

Zur Erhöhung der Stromtragfähigkeit der erzeugten HTSL-Schicht wird das Substrat bei dem Verfahren nach der DE 197 27 343 A1 in einer gegenüber dem Einsatz des fertigen Produkts derart anderen geometrischen Form mit dem supraleitfähigen Material beschichtet, dass in der supraleitfähigen Schicht in der im Einsatzfall vorliegenden geometrischen form des Substrats eine Druckspannung in der Substratebene erzeugt wird. Bei diesem Verfahren wird das supraleitfähige Material so auf das Substrat aufgebracht, dass es zunächst mit dem Substrat eine andere geometrische Form hat und erst in seiner dem jeweiligen Verwendungszweck entsprechenden Form bzw. Gestalt unter Druckspannung gesetzt wird. Allein durch diese Maßnahme wird die Stromtragfähigkeit des erzeugten HTSL-Materials wesentlich erhöht. Auch dieses in der Praxis bewährte Verfahren arbeitet aber langsam mit einer maximalen Beschichtungsrate von 10 nm x $cm^2$/s. Eine Erhöhung der Wiederholungsrate der Laserpulse mit dem Ziel die Beschichtungsrate zu vergrößern, würde hier zu einer Verschlechterung der HTSL-Parameter in der abgeschiedenen Schicht führen.

Durch EP 0 469 603 A2 ist ein Verfahren zur Erzeugung einer supraleitfähigen Schicht auf einem langgestreckten Substrat bekannt, bei welchem das Substrat durch eine Depositionskammer gezogen und innerhalb derselben in einer Heizzone beheizt wird, bei wlechem das Substrat in der Heizzone mit supraleitfähigem Material beschichtet wird, das mittels eines gepulsten Laserstrahls von einem in der Depositionskammer befindlichen, supraleitfähiges Material tragenden Target gelöst und als Plasmastrahl auf dem Substrat abgeschieden wird, und bei welchem der Laserstrahl während des Beschichtungsvorgangs in einer gleich bleibenden Ebene so in Schwingungen versetzt wird, dass er eine größere Fläche des Targets überstreicht. Dabei werden zwei voneinander getrennte Spiegel eingesetzt, durch welche der schwingende Laserstrahl auf das supraleitfähiges Material tragende Target umgelenkt wird. Die beiden Spiegel können durch elektromagnetische Antriebe so verstellt werden, dass der Laserstrahl die gesamte, das supraleitfähige Material tragende Oberfläche des Targets überstreichen kann. Dieses bekannte Verfahren ist insgesamt aufwändig und wegen der beiden Spiegel auch störanfällig.

Das Verfahren der eingangs erwähnten Art ist durch Usoskin et al. Appl. Phys. A 69 (1999) Seiten 423-425 bekannt. Durch die zusätzliche Drehung des Targets wird der notwendige schräge Azimutwinkel für die Oberfläche des Targets quasi gespiegelt, wodurch eine Vergleichmäßigung des Abtrags des supraleitfähigen Materials von dem Target erreicht wird.

Der vorliegenden Erfindung liegt die Aufgabe zugrunde, das bekannte Verfahren zur Verbesserung der Beschichtung des Substrats weiter zu bilden.

Diese Aufgabe wird erfindungsgemäß mit dem Verfahren der eingangs erwähnten Art dadurch gelöst, dass das Target um 180° gedreht wird, wenn der Laserstrahl die gesamte Länge des Targets mindestens einmal und höchstens zehnmal überstrichen hat und dass der Laserstrahl während der periodischen Bewegung des Targets quer zur Schwingungsebene des Laserstrahls und während der periodisch durchgeführten Drehung des Targets um 180° unterbrochen wird.

Mit diesem Verfahren kann die integrale Beschichtungsrate bei gleich bleibender Qualität der Beschichtung etwa um den Faktor 10 erhöht werden. Ein Grund hierfür ist die Erhöhung der Beschichtungsrate durch schnelles Überstreichen der gesamten, supraleitfähiges Material tragenden Fläche des Targets mit dem in Schwingungen versetzten gepulsten Laserstrahl. Es wird dadurch im gleichen Zeitraum eine wesentlich größere Fläche des Substrats mit supraleitfhigem Material beschichtet. Die auf eine Flächeneinheit der zu beschichtenden Fläche bezogene Beschichtungsrate ist bei diesem Verfahren nicht erhöht. Die Qualität der Beschichtung bleibt daher zumindest erhalten. Das gilt insbesondere auch für die Stromdichte. Erzielt werden diese Vorteile durch eine sehr einfache Verfahrensweise, gemäß der das Target während der Beschichtung einerseits verschoben und andererseits gedreht wird. Das kann mechanisch mit einfachen Mitteln durchgeführt werden. Der Laserstrahl wird dazu nicht gesondert beeinflusst. Durch die periodische Drehung des Targets um 180° ist ein zweiter Grund für eine stabile Erhöhung der Beschichtungsrate gegeben.

Das Verfahren nach der Erfindung wird anhand der Zeichnungen in Ausführungsbeispielen erläutert.

Es zeigen:

Fig. 1 in schematischer Darstellung eine Vorrichtung zur Durchführung des Verfahrens nach der Erfindung.
Fig. 2 einen Teil der Vorrichtung nach Fig. 1 im Schnitt.
Fig. 3 eine Einzelheit aus Fig. 1 in vergrößerter Darstellung.
Fig. 4 eine Draufsicht auf ein bei dem Verfahren verwendbares, supraleitfähiges Material tragendes Target.

In einer Depositionskammer 1 - im folgenden kurz "Kammer 1" genannt- wird beispielsweise ein Vakuum erzeugt und aufrechterhalten, in dem beispielsweise eine Sauerstoffatmosphäre mit einem Druck von 0,5 mbar gehalten wird. In der Kammer 1 sind eine vorzugsweise rohrförmige Heizzone 2, eine dieselbe umgebende Blende 3 mit einer Öffnung 4, ein elektrischer Motor M und ein supraleitfähiges Material tragendes Target 5 angeordnet. Ein von einem gepulsten Laser 6 ausgehender Laserstrahl 7 kann durch ein Fenster 8 in die Kammer 1 eintreten. Der Laserstrahl 7 trifft auf das Target 5. Die rohrförmig ausgebildete Heizzone 2 hat eine Öffnung 9, welche durch die drehbar gelagerte Blende 3 geöffnet und verschlossen werden kann. Die Blende 3 ist dazu durch den Motor M um ihre Achse drehbar. Das Target 5 ist mit Abstand zur Heizzone 2 vorzugsweise symmetrisch zu einer Linie 10 angebracht, die durch die Mitte der Öffnung 9 verläuft.

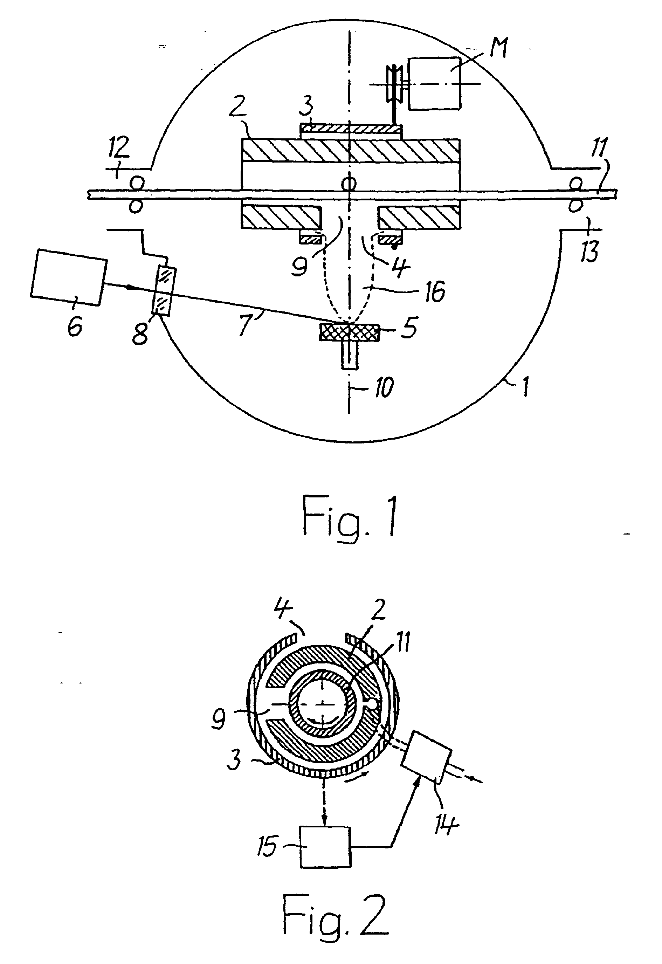

Durch die Kammer 1 wird gemäß der prinzipiellen Darstellung in Fig. 1 ein Substrat 11 aus einem beispielsweise mehrkristallinen Material in Richtung der eingezeichneten Pfeile gezogen. Es tritt durch eine Öffnung 12 in die Kammer 1 ein, durchläuft die Heizzone 2 und verläßt die Kammer 1 durch eine Öffnung 13. Das Substrat 11 kann in den Öffnungen 12 und 13 der Kammer 1 sowie in der Heizzone 2 durch Rollen geführt werden. Die in Fig. 2 als Kästchen eingezeichneten Anordnungen 14 und 15 dienen zur Steuerung des Laserstrahls 7 und zur Synchronisation der Blende 3 mit demselben.

Zur Durchführung des Verfahrens nach der Erfindung mit der aus Fig. 1 ersichtlichen Vorrichtung werden zunächst der Laser 6 und die Heizzone 2 eingeschaltet. Der auf das Target 5 auftreffende Laserstrahl 7 löst aus dessen Oberfläche Partikel des supraleitfähigen Materials, die durch einen gestrichelt angedeuteten Plasmastrahl 16 auf dem Substrat 11 abgeschieden werden. Das durch die Heizzone 2 gezogene Substrat 11 wird dadurch mit supraleitfähigem Material beschichtet.

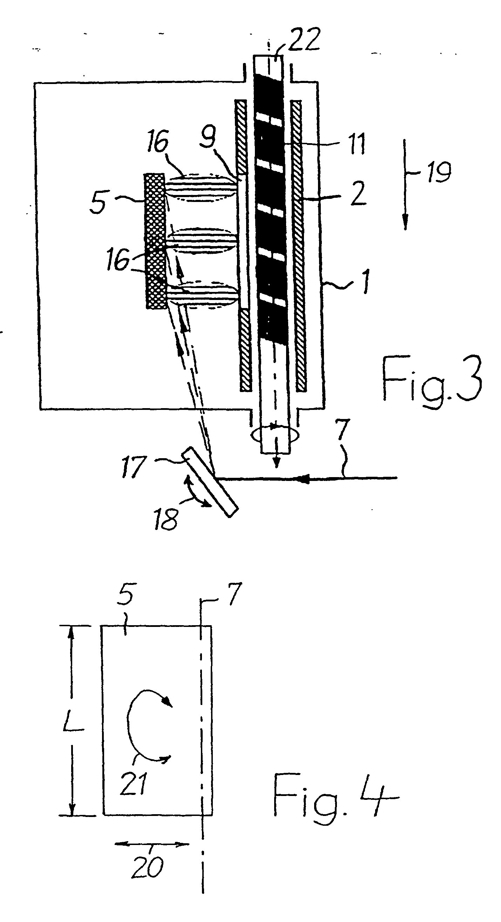

Bei dem Verfahren nach der Erfindung wird der Laserstrahl 7 während des Beschichtungsvorgangs so in Schwingungen versetzt, daß er in einer gleichbleibenden Ebene schwingt. Dazu kann ein Strahlablenker 17, in bevorzugter Ausführungsform ein Spiegel, verwendet werden, der entsprechend dem in Fig. 3 eingezeichneten Doppelpfeil 18 um einen einstellbaren Winkel hin- und herschwingt. Der Laserstrahl 7 kann dadurch in seiner Schwingungsebene so abgelenkt werden, daß er die gesamte Länge L des Targets 5 (Fig. 4) überstreicht, so wie es in Fig. 3 gestrichelt eingezeichnet ist. Der Strahlablenker (Spiegel) 17 kann gleichförmig hin- und herbewegt werden. Er kann jedoch auch nach Maßgabe einer symmetrischen oder unsymmetrischen Sägezahnkurve gesteuert werden, so daß der Laserstrahl 7 nach Maßgabe dieser Sägezahnkurve schwingt.

Das Target 5 wird beispielsweise so angeordnet, daß seine Oberfläche mit der größten Abmessung in der durch den Pfeil 19 angedeuteten Abzugsrichtung des zu beschichtenden Substrats 11 und parallel zu derselben verläuft. Während des Beschichtungsvorgangs wird das Target 5 periodisch in Richtung des in Fig. 4 eingezeichneten Pfeils 20 verschoben, also quer - vorzugsweise rechtwinklig - zu der Ebene, in welcher der Laserstrahl 7 schwingt. Die Verschiebung erfolgt immer dann, wenn der Laserstrahl 7 mindestens einmal die ganze Länge L des Targets 5 überstrichen hat. Auf diese Weise wird nach und nach die gesamte, supraleitfähiges Material tragende Fläche des Targets 5 durch den in einer gleichbleibenden Ebene schwingenden Laserstrahl 7 überstrichen.

Das Target 5 wird während des Beschichtungsvorgangs außerdem periodisch um 180° gedreht, so wie es in Fig. 4 durch den Pfeil 21 angedeutet ist. Durch diese Maßnahme werden das auf dem Target 5 vorhandene supraleitfähige Material besser ausgenutzt und insbesondere die Beschichtungsrate zusätzlich stabilisiert. Das Target 5 kann jeweils dann um 180° gedreht werden, wenn der Laserstrahl 7 seine ganze Länge L einmal überstrichen hat. Es wird spätestens dann um 180° gedreht werden, wenn es vom Laserstrahl 7 zehnmal überstrichen worden ist. Während der Verstellbewegungen (quer zum Laserstrahl 7 und Drehung um 180°) des Targets 5, wird der Laserstrahl 7 zweckmäßig jeweils kurzzeitig unterbrochen.

Die Öffnung 9 der Heizzone 2 und auch die Öffnung 4 der in Fig. 3 nicht eingezeichneten Blende 3 werden in ihrer axialen Länge den Abmessungen des Targets 5 angepaßt. An jeder Stelle, an welcher der gepulste Laserstrahl 7 auf die Oberfläche des Targets 5 auftrifft, werden - so wie es für Fig. 1 grundsätzlich beschrieben ist - Partikel des supraleitfähigen Materials aus der Oberfläche herausgelöst und durch Plasmastrahlen 16 auf dem Substrat 11 abgeschieden. In Fig. 3 sind drei Plasmastrahlen 16 eingezeichnet. Es kann auf diese Weise in gleichbleibender Zeit eine wesentlich größere Fläche des Substrats 11 mit supraleitfähigem Material beschichtet werden. Das Substrat 11 kann gemäß Fig. 3 als Band wendelförmig um ein Rohr 22 herumgewickelt werden, das während des Beschichtungsvorgangs um seine Achse gedreht und/oder linear bewegt werden kann. Die Beschichtungsrate kann dadurch weiter erhöht werden.

Das Target 5 wird mit dem Laserstrahl 7 vorzugsweise mit einer Frequenz F1 gemäß folgender Gleichung überstrichen:

$$F1 = K \times F / (L/A).$$

Darin sind K ein Koeffizient, der zwischen den Werten 0,5 und 8,0 liegt, F die Wiederholungsrate der Laserpulse in Hertz, L die Länge des Targets 5 in der Schwingungsebene des Laserstrahls 7 in mm und A eine Konstante, welche 1 mm entspricht.

Der empirisch ermittelte Koeffizient K bestimmt den zeitlichen Abstand, mit dem die Partikel durch den Laserstrahl 7 aus dem Target 5 gelöst werden. Wenn K kleiner als 0,5 ist, können sich Überlappungen ergeben, so daß Partikel zumindest teilweise auf der gleichen Stelle des Substrats 11 abgeschieden würden. Ein über 8,0 liegender Wert des Koeffizienten K führt zu keiner weiteren Verbesserung des Verfahrens.

Das Verfahren nach der Erfindung wird im folgenden durch vier Beispiele erläutert:

Beispiel 1

Als Substrat 1 wird eine 0,1 mm dicke Folie aus Nickel mit einer Länge von 1000 mm, einer Breite von 50 mm und einer biaxial texturierten dielektrischen Zwischenschicht verwendet. Für die Beschichtung mit einem HTSL-Material mit der Zusammensetzung $YBa_2CU_3O_{7-X}$ wird das Substrat 11 spiralförmig bzw. wendelförmig auf das Rohr 22 aufgewickelt und mit demselben in der mit der Blende 3 versehenen Heizzone 2 fixiert. Während des Auftreffens der Laserpulse auf das Target 5, das eine Länge L von 160 mm und eine Breite von 40 mm hat, rotiert das Rohr 22 um seine Achse und es bewegt sich linear in Richtung derselben. Das Target 5 wird mit dem Laserstrahl 7 mit einer gemäß obiger Gleichung berechneten Frequenz F1 von etwa 5 Hz überstrichen. Der Koeffizient K ist dabei 4,4. Die Wiederholungsrate der Laserpulse (308 nm, 20 ns) entspricht einer Frequenz von F = 180 Hz. Während der Abscheidung des supraleitfähigen Materials wird eine Sauerstoffatmosphäre von 0,3 mbar in der Kammer 1 aufrechterhalten und es wird zusätzlich Sauerstoff im Bereich der Heizzone 2 injiziert. Der Sauerstoff kann vorzugsweise pulsförmig injiziert werden, und zwar insbesondere zwischen den Laserpulsen. Zur Injizierung des Sauerstoffs kann in der Heizzone 2 ein Auslaß 23 angebracht sein, welcher der Öffnung 9 derselben diametral gegenüber liegt. Die integrale Beschichtungsrate entspricht dabei 115 nm x cm$^2$/s. Sie ist damit um das Zehnfache höher als bei den bisher bekannten Verfahren. Die kritische Stromdichte Jc der abgeschiedenen Schicht entspricht 7 kA/mm$^2$.

Beispiele 2 bis 4

Die Parameter für Target 5 und Beschichtungsmaterial sind die gleichen wie im Beispiel 1. Variiert werden jeweils nur der Koeffizient K und die Wiederholungsrate F der Laserpulse. Die entsprechenden Werte gehen ebenso wie die des Beispiels 1 aus der unten angegebenen Tabelle hervor. In der Tabelle sind auch die jeweilige Schwingfrequenz F1, die Stromdichte Jc und die Beschichtungsrate BR eingetragen.

|  | K | F | F1 | Jc | BR |
|---|---|---|---|---|---|
| Beispiel 1 | 4,4 | 180 Hz | 5 Hz | 7 kA/mm$^2$ | 115 nm x cm$^2$/s |
| Beispiel 2 | 1,5 | 294 Hz | 2,8 Hz | 5,5 kA/mm$^2$ | 180 nm x cm$^2$/s |
| Beispiel 3 | 0,5 | 294 Hz | 0,9 Hz | 3,5 kA/mm$^2$ | 185 nm x cm$^2$/s |

(fortgesetzt)

|  | K | F | F1 | Jc | BR |
|---|---|---|---|---|---|
| Beispiel 4 | 8,0 | 140 Hz | 7 Hz | 6 kA/mm$^2$ | 80 nm x cm$^2$/s |

**Patentansprüche**

1. Verfahren zur Erzeugung einer supraleitfähigen Schicht auf einem langgestreckten Substrat (11), bei dem das Substrat (11) durch eine Depositionskammer (1) gezogen und innerhalb derselben in einer Heizzone (2) beheizt wird, bei dem das Substrat (11) in der Heizzone (2) mit supraleitfähigem Material beschichtet wird, das mittels eines gepulsten Laserstrahls (7) von einem in der Depositionskammer (1) befindlichen, supraleitfähiges Material tragenden Target (5) gelöst und als Plasmastrahl (16) auf dem Substrat (11) abgeschieden wird, und bei dem der Laserstrahl (7) während des Beschichtungsvorgangs in einer gleich bleibenden Ebene so in Schwingungen versetzt wird, dass er eine große Fläche des Targets (5) überstreicht, wobei das Target (5) während des Beschichtungsvorgangs periodisch quer zur Schwingungsebene des Laserstrahls (7) bewegt wird und das Target (5) während des Beschichtungsvorgangs in der Ebene seiner vom Laserstrahl (7) überstrichenen Fläche zusätzlich periodisch um 180° gedreht wird, **dadurch gekennzeichnet, dass** das Target (5) um 180° gedreht wird, wenn der Laserstrahl (7) die gesamte Länge (L) des Targets (5) mindestens einmal und höchstens zehnmal überstrichen hat und dass der Laserstrahl (7) während der periodischen Bewegung des Targets (5) quer zur Schwingungsebene des Laserstrahls (7) und während der periodisch durchgeführten Drehung des Targets (5) um 180° unterbrochen wird.

2. Verfahren nach Anspruch 1, **dadurch gekennzeichnet, dass** die Frequenz (F1) der Schwingungen des Laserstrahls (7) der Gleichung

$$F1 = K \times F/(L/A)$$

entspricht, worin K ein Koeffizient, der zwischen den Werten 0,5 und 8,0 liegt, F die Wiederholungsrate der Laserpulse in Hertz, L die Länge des Targets in der Schwingungsebene des Laserstrahls (7) in mm und A eine Konstante sind, welche 1 mm entspricht.

3. Verfahren nach Anspruch 1 oder 2, **dadurch gekennzeichnet, dass** der Laserstrahl (7) nach Maßgabe einer Sägezahnkurve in Schwingungen versetzt wird.

4. Verfahren nach einem der Ansprüche 1 bis 3, **dadurch gekennzeichnet, dass** das Substrat (11) wendelförmig um ein Rohr (22) herumgewickelt wird.

5. Verfahren nach Anspruch 4, **dadurch gekennzeichnet, dass** das Rohr (22) während der Beschichtung um seine Achse gedreht wird.

6. Verfahren nach Anspruch 4, **dadurch gekennzeichnet, dass** das Rohr (22) während der Beschichtung linear bewegt wird.

7. Verfahren nach einem der Ansprüche 1 bis 6, **dadurch gekennzeichnet, dass** Sauerstoff in den Bereich der Heizzone (2) injiziert wird.

8. Verfahren nach Anspruch 7, **dadurch gekennzeichnet, dass** der Sauerstoff pulsförmig injiziert wird.

9. Verfahren nach Anspruch 7 oder 8, **dadurch gekennzeichnet, dass** der Sauerstoff zwischen den Laserpulsen injiziert wird.

10. Verfahren nach einem der Ansprüche 7 bis 9, **dadurch gekennzeichnet, dass** der Sauerstoff der Öffnung (9) diametral gegenüberliegend in die Heizzone (2) injiziert wird.

**Claims**

1. Method for producing a superconducting layer on an elongated substrate (11), in which the substrate (11) is drawn through a deposition chamber (1) and heated within the latter in a heating zone (2), in which the substrate (11) is coated with superconducting material in the heating zone (2), said superconducting material being released from a target (5) - which is situated in the deposition chamber (1) and carries superconducting material - by means of a pulsed laser beam (7) and being deposited on the substrate (11) as a plasma jet (16), and in which the laser beam (7) is caused to effect oscillations during the coating operation in a constant plane such that it sweeps over a large area of the target (5), the target (5) being moved periodically transversely with respect to the plane of oscillation of the laser beam (7) during the coating operation and the target (5) additionally being rotated periodically 180° in the plane of its area swept over by the laser beam (7) during the coating operation, **characterized in that** the target (5) is rotated through 180° if the laser beam (7) has swept over the entire length (L) of the target (5) at least once and at most ten times, and **in that** the laser beam (7) is interrupted during the periodic movement of the target (5) transversely with respect to the plane of oscillation of the laser beam (7) and during the periodically performed rotation of the target (5) through 180°.

2. Method according to Claim 1, **characterized in that** the frequency (F1) of the oscillations of the laser beam (7) corresponds to the equation

$$F1 = K \times F/(L/A)$$

wherein K is a coefficient lying between the values 0.5 and 8.0, F is the repetition rate of the laser pulses in hertz, L is the length of the target in the plane of oscillation of the laser beam (7) in mm, and A is a constant corresponding to 1 mm.

3. Method according to Claim 1 or 2, **characterized in that** the laser beam (7) is caused to effect oscillations in accordance with a sawtooth curve.

4. Method according to one of Claims 1 to 3, **characterized in that** the substrate (11) is wound helically around a tube (22).

5. Method according to Claim 4, **characterized in that** the tube (22) is rotated about its axis during the coating.

6. Method according to Claim 4, **characterized in that** the tube (22) is moved linearly during the coating.

7. Method according to one of Claims 1 to 6, **characterized in that** oxygen is injected into the region of the heating zone (2).

8. Method according to Claim 7, **characterized in that** the oxygen is injected in a pulsed manner.

9. Method according to Claim 7 or 8, **characterized in that** the oxygen is injected between the laser pulses.

10. Method according to one of Claims 7 to 9, **characterized in that** the oxygen is injected into the heating zone (2) diametrically opposite the opening (9).

**Revendications**

1. Procédé pour l'obtention d'une couche supraconductrice sur un substrat (11) étiré en longueur, dans lequel le substrat (11) est étiré dans une chambre de dépôt (1) et est chauffé à l'intérieur de celle-ci dans une zone de chauffage (2), dans lequel, le substrat (11) est revêtu dans la zone de chauffage (2) par une matière supraconductrice, au moyen d'un faisceau laser pulsé (7) qui libère la matière supraconductrice portée par une cible (5) située dans la chambre de dépôt (1) qui est déposée sur le substrat (11) sous forme de faisceau de plasma (16), dans lequel le faisceau laser (7), lors du déroulement du revêtement est déplacé selon des oscillations maintenues dans un même plan, de façon qu'il balaie une grande surface de la cible (5), la cible (5) étant déplacée pendant le déroulement du revêtement périodiquement transversalement au plan des oscillations du faisceau laser (7) et la cible (5) étant en outre tournée périodiquement de 180° pendant le déroulement du revêtement dans le plan de sa surface balayée par le faisceau laser (7), **caractérisé en ce que** la cible (5) est tournée de 180° lorsque le faisceau laser (7) a balayé la totalité de la longueur (L) de la cible (5) au moins une fois et au plus dix fois celle-ci et **en ce que** le faisceau laser (7) est interrompu pendant le déplacement périodique de la cible (5) transversalement au plan des oscillations du faisceau laser (7) et pendant le déroulement de la rotation périodique de la cible (5) de 180°.

2. Procédé selon la revendication 1, **caractérisé en ce que** la fréquence (F1) des oscillations du faisceau laser (7) est égale à la relation

$$F1 = K \times F/ (L/A)$$

dans laquelle K est une coefficient situé entre les valeurs 0,5 et 8,0, F la périodicité des impulsions laser en Hertz, L la longueur de la cible dans le plan des oscillations du faisceau laser (7) en mm et A une constante égale à 1mm.

3. Procédé selon la revendication 1 ou 2, **caractérisé en ce que** le faisceau laser (7) est déplacé essentiellement selon des oscillations dont la courbe est en dents de scie.

4. Procédé selon l'une des revendications 1 à 3, **caractérisé en ce que** le substrat (11) est enroulé hélicoïdalement autour d'un tube (22).

5. Procédé selon la revendication 4, **caractérisé en ce que** le tube (22) est entraîné en rotation autour de son axe pendant le revêtement.

6. Procédé selon la revendication 4, **caractérisé en ce que** le tube (22) est déplacé linéairement pendant le revêtement.

7. Procédé selon l'une des revendications 1 à 6, **caractérisé en ce que** de l'oxygène est injecté dans la zone de chauffage (2).

8. Procédé selon la revendication 7, **caractérisé en ce que** l'oxygène est injecté de façon pulsée.

9. Procédé selon la revendication 7 ou 8, **caractérisé en ce que** l'oxygène est injecté entre les impulsions laser.

10. Procédé selon l'une des revendications 7 à 9, **caractérisé en ce que** l'oxygène est injecté dans la zone de chauffage, diamétralement à l'opposé de l'ouverture (9).

Fig. 1

Fig. 2

Fig.3

Fig. 4